# EUROPÄISCHE PATENTSCHRIFT

(11) **EP 1 569 865 B1**
(45) Veröffentlichungstag und Bekanntmachung des Hinweises auf die Patenterteilung: **13.02.2008**
(21) Anmeldenummer: 03782134.5
(22) Anmeldetag: 05.12.2003
(51) Int. Cl.: B81C 1/00, B81C 3/00, B81B 3/00

(54) **Herstellen von mikroelektromechanischen Systemen (MEMS) über ein Silizium-Hochtemperatur-Fusionsbonden von Scheiben**
Production of microelectromechanical systems (MEMS) using the high-temperature silicon fusion bonding of wafers
Fabrication de microsystèmes électromécaniques(MEMS) par liaison de plaquettes par fusion haute température du silicium

(30) Priorität: 05.12.2002 DE 10257097
(43) Veröffentlichungstag der Anmeldung: 07.09.2005
(73) Patentinhaber: X-FAB Semiconductor Foundries GmbH, 99097 Erfurt (DE)
(72) Erfinder: SCHWARZ, Uwe, 99102 Erfurt-Niedernissa (DE)
(74) Vertreter: Fricke, Joachim
(86) Internationale Anmeldenummer: PCT/DE2003/004015
(87) Internationale Veröffentlichungsnummer: WO 2004/050546

(56) Entgegenhaltungen:
- WO-A-00/36385
- US-A- 4 463 336
- US-A- 6 012 336
- PARAMESWARAN L ET AL: "A merged MEMS-CMOS process using silicon wafer bonding" ELECTRON DEVICES MEETING, 1995., INTERNATIONAL WASHINGTON, DC, USA 10-13 DEC. 1995, NEW YORK, NY, USA,IEEE, US, 10. Dezember 1995 (1995-12-10), Seiten 613-616, XP010161161 ISBN: 0-7803-2700-4
- PETERSEN K ET AL: "Fabrication of SOI wafers with buried cavities using silicon fusion bonding and electrochemical etchback" SENSORS AND ACTUATORS A, ELSEVIER SEQUOIA S.A., LAUSANNE, CH, Bd. 54, Nr. 1-3, 1. Juni 1996 (1996-06-01), Seiten 709-713, XP004077953 ISSN: 0924-4247

## Beschreibung

Die Erfindung betrifft ein Verfahren zur Herstellung von MEMS und einen Sensor. Der Sensor und die sensorsignal-verarbeitende Elektronik sind monolithisch integriert.

Parameswaran et al. in "A merged MEMS-CMOS process using silicon wafer bonding" ELECTRON DEVICES MEETING, 1995., INTERNATIONAL WASHINGTON, DC, USA 10-13 DEC. 1995, NEW YORK, NY, USA,IEEE, US, 10. Dezember 1995 (1995-12-10), Seiten 613-616, XP010161161 ISBN: 0-7803-2700-4 beschreiben ein Verfahren zum Herstellen von MEMS-Strukturen und CMOS-Strukturen, wobei eine N-dotierte Epitaxieschicht auf eine P-dotierte Siliziumscheibe aufgebracht wird. Diese Scheibe mit der N-dotierten Epitaxieschicht wird auf eine zweite Scheibe mit Vertiefungen gebondet, und die N-dotierte Schicht tragende Scheibe zunächst durch Schleifen polierend in ihrer Dicke reduziert. Abschließend findet ein Nassätzprozess statt, wobei der durch das Bonden erhaltene PN-Übergang als elektrochemischer Ätzstopp dient. Nach dem Inhalt dieser Schrift sind das Schleifen und Polieren als erste Schritte auszuführen, und abschließend das elektrochemische Ätzen, welches an der N-dotierten Epitaxieschicht anhält, um gleichförmige Membranen zu erhalten, vgl. a.a.O., Seite 613, rechte Spalte, letzter Abschnitt.

Anders beschreibt US-A 4 463 336 (deMaria, Black) ein Verfahren, bei dem ein anodisches Scheibenbonden verwendet wird, wozu das Aufbringen einer Borsilikat-Glasschicht erforderlich ist. Eine hochdotierte Schicht wird für einen elektrochemischen Ätzstopp eingesetzt.

Aus US-A 6 012 336 (Sandia, Eaton et al.), dort insbesondere Spalte 1, Zeilen 26 bis 35, werden Vorteile von mikromechanischer Integration im Sinne der Monolithic Integration gezeigt, und dabei besonders Größe und Kosten angesprochen, verbunden damit, dass diese monolithische Integration auch durchgeführt werden kann, vgl. dort beispielsweise Figur 3.

DE-A 199 27 970 und DE-A 199 27 971 beschreiben, dass zur Erzeugung der Kavitäten eine Zwischenschicht dient, die auf eine der beiden Halbleiterscheiben aufgebracht wird. In dieser Zwischenschicht werden Ausnehmungen (Einsenkungen) erzeugt. Über die Zwischenschicht auf der einen Halbleiterscheibe wird diese mit einer zweiten Halbleiterscheibe verbunden. Danach wird eine der beiden Halbleiterscheiben bis auf die der Membran entsprechenden Dicke abgedünnt, womit über der Kavität eine Membran ausgebildet wird. Da in diesen Fällen die elektronischen Strukturen im homogen dotierten Scheibenmaterial erzeugt werden, die Scheiben mittels einer auf eine Halbleiterscheibe aufgebrachten Zwischenschicht verbunden werden, handelt es sich offenbar nicht um Hochtemperatur-Fusionsbonden. Da ferner die Herstellung von Drucksensoren beschrieben ist, kann davon ausgegangen werden, dass CMOSspezifische Verfahren für hohe Integrationsdichten und hohe Werte der Zuverlässigkeit und Ausbeute nicht vorteilhaft eingesetzt werden können. Defekte, die im homogenen Scheibenmaterial (Czochralski-Silizium) vorhanden sind, verhindern z.B. die Herstellung eines qualitativ hochwertigen Gateoxids.

Bekannt ist andererseits aus der US-A 5,295,395 im Zusammenhang mit der Beschreibung der Herstellung eines Membrandrucksensors eine erste Halbleiterscheibe mit einer Epitaxieschicht entgegengesetzter Dotierung, über welche diese mit einer zweiten Halbleiterscheibe durch Fusionsbonden verbunden wird, wonach eine Abtragung der ersten Halbleiterscheibe bis auf die Epitaxieschicht so erfolgt, dass die Membran durch die Epitaxieschicht gebildet wird. Ein Hinweis auf die nachträgliche Erzeugung von signalverarbeitenden elektronischen Schaltungen auf der Oberfläche der Epitaxieschicht ist nicht gegeben. Vielmehr muss man aus der Patentschrift entnehmen, dass nach dem Scheibenbonden kein weiterer Hochtemperaturschritt mehr angebracht ist, weil zur Vermeidung von Verformungen der Scheibenbereiche der Deckscheibe über den Einsenkungen beim Scheibenverbinden eine Füllsubstanz in den Einsenkungen nötig war, die später wieder entfernt wurde.

MEMS werden seit Jahren auf der Basis von Silizium-Technologien hergestellt. Als MEMS wurden ursprünglich Sensoren bezeichnet, die sich aus einem mikromechanischen Teil und einem mikroelektronischen Teil zusammensetzen. Die Herstellungsverfahren können nach ihrem mikromechanischen Aufbau im wesentlichen in zwei Kategorien eingeteilt werden. Einerseits wird eine Siliziumscheibe in ihrer ganzen vertikalen Dimension, d.h. **in die Tiefe** hinein bearbeitet, um Strukturen zur Detektion mechanischer Größen, z.B. Druck und Beschleunigung herzustellen (bulkmicromachining Technologies). Andererseits werden solche Strukturen nur **an der Oberfläche** der Siliziumscheibe erzeugt (surface-micromachining Technologies).

Während anfänglich die Sensoren zur Detektion mechanischer Größen und die signalverarbeitende Elektronik, z.B. digitale integrierte Schaltkreise, getrennt waren, zwingt der technische Fortschritt heute zur monolithischen Integration beider. Die Integration von mikromechanischen Sensoren und elektronischen Schaltungen auf einem Chip stellt hohe Anforderungen an die Herstellungstechnologie, da die Herstellungsprozesse der Sensoren häufig nicht kompatibel zu denen der hochintegrierten CMOS-Technologien mit z.B. Strukturgrößen ≤ 1µm sind. Kompromisse hinsichtlich erreichbarer Daten (Empfindlichkeit, Genauigkeit, Messbereich), Integrationsgrad (Strukturgrößen), Zuverlässigkeit und Kosten stehen an.

Die für den Teil der mikromechanischen Sensoren der MEMS bekannte spezifische Verfahrensweise besteht in der Strukturierung eines Kavitätenkörpers, zumeist einer Kavitätenscheibe (Kavitäten-Wafer), durch halbleiterübliche Prozessschritte wie Oxidation, Fotolithografie und nasschemisches Ätzen. Dadurch werden Vertiefungen in das Silizium geätzt, die später durch Überdeckung zu Hohlräumen (Kavitäten) werden über denen sich die Silizium-Membran oder andere sich unter mechanischen Belastungen bewegende Sensorelemente befinden. Nach Strukturierung des KavitätenKörpers wird dieser mit der Seite, welche die Einsenkungen besitzt, durch ein Scheibenbondverfahren mit einer Abdeckscheibe (top-cap Wafer) untrennbar verbunden, so dass aus den Vertiefungen Hohlräume entstehen. Anschließend wird der so entstandene Scheibenstapel durch Siliziumschleif- und Polierprozesse, wie sie standardmäßig in der Halbleiterherstellung verwendet werden, bearbeitet, so dass die Abdeckscheibe stark abgedünnt wird.

Aufgabe der Erfindung ist die Steigerung der Empfindlichkeit und der Zuverlässigkeit sowie die Senkung der Herstellung- und Anwendungskosten von MEMS mit integrierter Auswertelektronik. Ausserdem soll eine Verbesserung des Herstellungsverfahrens erreicht werden, so dass der sensorspezifische Teil und der Teil der auf CMOS-Technologie beruhende Teil der Auswerteelektronik der MEMS mit einer vereinheitlichten Technologie monolithisch hergestellt werden können.

Die Aufgabe wird mit den im Anspruch 1 beschriebenen Schritten gelöst. Weiterbildungen der Erfindung sind den abhängigen Ansprüchen zu entnehmen.

Durch die Spezifikationen des Scheibenmaterials der Deckscheibe und speziell der von dieser getragenen Epitaxieschicht (Dotierstoff, Schichtwiderstand, Defektstruktur), welche im speziellen Fall die Dicke der gewünschten Membran haben kann, sowie Anwendung des Hochtemperatur-Fusionsbondens zum Verbinden zweier Halbleiterscheiben können die Anforderungen für die Anwendung einer CMOS-Technologie erfüllt werden (Anspruch 1).

Es liegt im Rahmen der Erfindung, dass in die Epitaxieschicht der Deckscheibe bereits vor dem Scheibenbonden elektronische Strukturen eingebracht werden (Anspruch 2), die so ausgelegt sind, dass sie von den nachfolgenden Hochtemperaturbehandlungen nicht mehr wesentlich verändert werden oder mit diesen fertig präpariert werden, was zu einer Verdichtung der elektronischen Strukturen oder/und auch zu einer Datenverbesserung beitragen kann.

Bei dem erfindungsgemäßen Verfahren handelt es sich um eine Verknüpfung beider eingangs gezeigten Technologiearten der Bulk- und Surface Technologie.

Der elektronische Teil der Sensoren und die signalverarbeitende Elektronik in Form von hochintegrierten Schaltkreisen kann monolithisch integriert mit denselben Herstellungsverfahren ausgebildet werden.

Die Erfindung wird anhand von Ausführungsbeispielen erläutert und ergänzt, wobei darauf hingewiesen wird, daß es sich bei der folgenden Darstellung um die Beschreibung von bevorzugten Beispielen der Erfindung handelt.
- **Figur 1**: ist ein Beispiel eines Scheibenverbundes aus einem Bulk-Wafer 2 und einem EPI-Wafer 1, die über ein High-Temperature Silicon-Fusing-Bonding miteinander verbunden sind, zur Bildung eines Scheibenverbundes oder -verbands.
- **Figur 2**: ist ein Beispiel eines Absolutdruck-Sensors, unter Verwendung des Scheibenverbands der Figur 1.

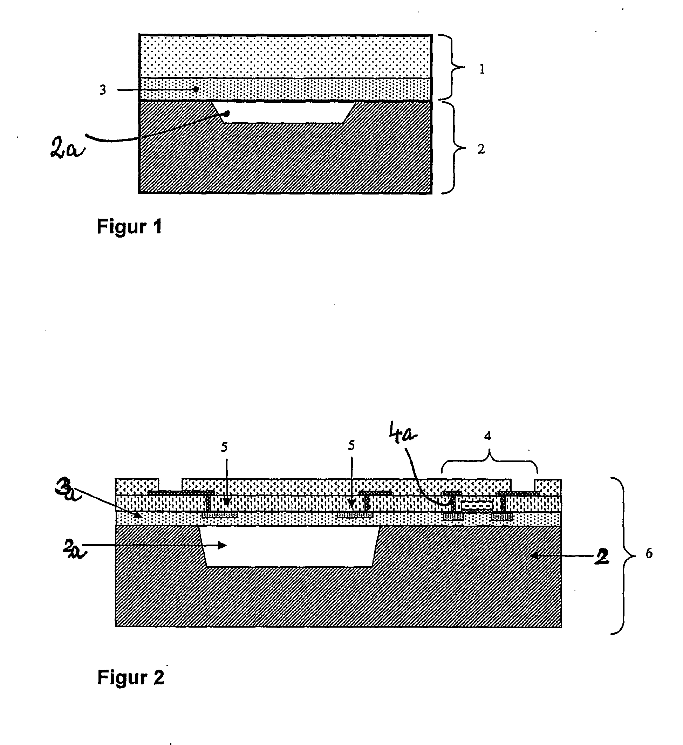

**Figur 1** zeigt eine Zusammenfügung von zwei Halbleiterscheiben, hier SiliziumScheiben, die nicht gleich ausgestaltet sind. Sie dienen dem Verfahren zur Herstellung von mikroelektromechanischen Sensoren, wobei die Sensoren und die Signalverarbeitungs-Elektronik monolithisch integriert ausgeführt sind.

Die erste Scheibe 2 ist als Siliziumscheibe ausgebildet. Sie trägt eine Kavität 2a. Es sind auch mehrere Kavitäten möglich, bloß zur Erläuterung eine Kavität hier heraus vergrößert, aus einem größeren Wafer. Der EPI-Wafer trägt ein Substrat aus Silizium und eine Epitaxieschicht, die mit 3 benannt ist. Diese beiden Wafer 1 und 2 werden durch Hochtemperatur-Fusions-Boden über die Epitaxieschicht 3, bzw. deren Oberfläche fest miteinander verbunden. Die Einsenkung oder Kavität 2a wird abgedeckt und bildet einen geschlossenen Hohlraum.

Der Scheibenverband aus beiden Scheiben ist in Figur 2 weiter prozessiert worden. Der Scheibenverband wurde von der zweiten Scheibe 1 her bis zur Epitaxieschicht 3 ausgedünnt, bzw. abgetragen. Der Rest 3a (Restdicke) der verbleibenden Epitaxieschicht 3 ist in Figur 2 ersichtlich und deckt den Hohlraum 2a zur Bildung einer Kavität 2a (geschlossener Hohlraum) ab.

Die Ausdünnung erfolgte bis zu einer Dicke herab, die einer Membrandicke entspricht, um durch mechanische Verformung dieser Membran Messsignale aufnehmen zu können. Die Membrandicke der verbliebenen Membran 3a entspricht dem mikromechanischen Teil eines Sensors 5, der in Figur 2 schematisch als Drucksensor eingezeichnet ist. Die Drucksensoren 5 liegen oberhalb der Kavität 2a (sind zur Kavität positioniert). Die Ausdünnung kann aber auch auf eine andere Dicke erfolgen, entsprechend einer Dicke eines anderen auf mechanische Beanspruchung sensiblen Teils der Halbleiterscheibe, ohne gesonderte Darstellung.

Es schließt sich der Verfahrensschritt des Polierens an, der nicht gesondert dargestellt wird.

Nach dem Polierprozess wird eine zur Kavität positionierte elektronische Sensorstruktur 4 gemeinsam mit einer oder mehreren analogen und/oder einer oder mehreren digitalen Schaltungen auf der polierten Oberfläche über ein geeignetes Technologieverfahren erzeugt, im Beispiel ein CMOS-Technologieverfahren, zur Bildung des gesamten SOS-Wafers 6, der als Waferstapel benannt werden kann.

Die Sensoren 5 liegen in der verbliebenen EPI-Schicht 3a. Die Schaltungselemente 4 sind auf der verbliebenen EPI-Schicht und zeigen normale elektrische Eigenschaften.

Durch das Verfahren wird ein sicherer Gesamtprozess mit hoher Ausbeute erzielt, der für hochvolumige Produktionen geeignet ist.

Die Einbringung der Strukturen elektronischer Schaltungen in die Epitaxieschicht kann auch vor dem Verbindungsprozess der Scheiben (vor dem Bonden) nach Figur 1 erfolgen (nicht gesondert dargestellt).

Die EPI-Schicht 3 trägt dann bereits Strukturen der elektronischen Schaltungen auf der Seite, die nach der Verbindung der Kavität 2a zur Bildung des geschlossenen Hohlraums zugewandt ist (auch ohne gesonderte Darstellung). Die elektronischen Strukturen auf der, der Kavität 2a zugewandten Seite, können zumindest nach dem Bonden der Scheiben zur polierten Seite (bzw. Oberfläche) durchgreifen, z.B. elektrisch leitende Kanäle bilden, was nicht gesondert dargestellt ist.

Auf der der Kavität 2a zugewandten Seite meint, dass die zugehörigen elektronischen Strukturen zumindest teilweise in der Schicht bzw. Membran 3a liegen oder dort hineinreichen.

Die der Kavität 2a zugewandte Seite hat mit den besagten elektronischen Strukturen zumindest einen nicht dargestellten Sensor, der für die Anlayse des einer Membran 3a in der Kavität 2a anliegenden Mediums geeignet ist.

Die allgemeinen Technologieverfahren, auf die Bezug genommen wurde, zur Schaffung der elektronischen Sensorstrukturen 4 brauchen nicht gesondert beschrieben zu werden, sondern sind als CMOS-Technologieverfahren allgemein bekannt.

Es wird ein Verfahren zur Herstellung eines mikroelektromechanischen Systems (Microelectromechanical System: MEMS) beschrieben, das monolithisch integriert den Sensor mit der sensorsignalverarbeitenden Elektronik auf CMOS-Technologie-Basis enthält. Durch Verbinden einer Vertiefungen besitzenden Halbleiterscheibe (2) mit einer eine Epitaxieschicht tragenden Scheibe über die Epitaxieschicht (3) mittels Hochtemperatur-Fusionsbonden zu einer Doppelscheibe und anschließenden einseitigen Abtrag der Doppelscheibe mit nachfolgender Politur bis zur Freilegung der Epitaxieschicht bei gleichzeitiger Schaffung einer Membran (3a), werden die Voraussetzungen geschaffen, um den elektronischen Teil (4) des Sensors (5) und die signalverarbeitende Elektronik mit CMOS-Technologieverfahren zu realisieren.

## Patentansprüche

1. Verfahren zur Herstellung von mikroelektromechanischen Sensoren (MEMS), bei denen Sensoren (5) und sensor-signalverarbeitende Elektronik (4) monolithisch integriert ausgeführt sind oder werden;
(i) indem eine Kavitäten (2a) enthaltende erste Siliziumscheibe (2) mit einer zweiten, eine Epitaxieschicht (3) tragenden Scheibe (1) durch ein Hochtemperatur-Fusionsbonden über die Epitaxieschicht fest miteinander so verbunden werden, dass diese Epitaxieschicht mindestens eine der Kavitäten (2a) abdeckt, und ein Scheibenverband gebildet wird;
(ii) der Scheibenverband von der zweiten Scheibe (1) her bis in die Epitaxieschicht (3) auf eine dem mikromechanischen Teil des Sensors (5) entsprechende Membrandicke oder Dicke eines anderen auf mechanische Beanspruchung sensiblen Teils abgetragen und dabei abschließend poliert wird, zur Bildung einer polierten Oberfläche;
(iii) wobei nach dem Polierprozess zu der mindestens einen Kavität (2a) positionierte elektronische Sensorstrukturen (5) gemeinsam mit analogen oder/und digitalen Schaltungen (4) auf der polierten Oberfläche mittels CMOS-Technologieverfahren erzeugt werden.

2. Verfahren nach Anspruch 1, wobei vor dem Scheibenverbindungsprozess in der Epitaxieschicht (3) bereits Strukturen elektronischer Schaltungen (4) auf der Seite vorhanden sind, die nach der Verbindung der mindestens einen Kavität (2a) zugewandt ist.

3. Verfahren nach Anspruch 1, wobei einige elektronische Sensorstrukturen (5) auf der der Kavität zugewandten Seite vorgesehen sind, und zumindest nach dem Scheibenverbinden (1,2) zur polierten Oberfläche durchgreifen.

4. Verfahren nach Anspruch 3, wobei die einigen elektronischen Sensorstrukturen elektrisch leitende Kanäle (4a) bilden.

5. Verfahren nach Anspruch 2, wobei die bereits vorhandenen Strukturen elektronischer Schaltungen (4) auf der der mindestens einen Kavität (2a) zugewandten Seite zumindest nach dem Scheibenverbinden zur polierten Oberfläche durchgreifen.

6. Verfahren nach Anspruch 5, wobei die Strukturen der elektronischen Schaltungen elektrisch leitende Kanäle (4a) bilden.

7. Verfahren nach Anspruch 1, wobei auf der - der Kavität (2a) zugewandten - Seite der abgetragenen Epitaxieschicht (3a) vorhandene elektronische Sensorstrukturen (5) solche Sensoren für eine Analyse eines in der Kavität (2a) enthaltenen Mediums aufweisen.

8. Verfahren nach Anspruch 1, wobei das Abtragen auf eine dem mikromechanischen Teil des Sensors (5) entsprechende Membrandicke (3a) oder eine Dicke eines anderen, auf mechanische Beanspruchung ansprechenden Teils der zweiten Scheibe (1) erfolgt.

9. Verfahren nach Anspruch 3, wobei die elektronischen Strukturen des Sensors auf der der Kavität zugewandten Seite zumindest nach dem Scheibenbonden zur polierten Seite durchgreifen und elektrisch leitende Kanäle (4a) aufweisen.

10. Verfahren nach Anspruch 7, wobei das Medium in der Kavität (2a) an der Membran (3a) anliegt, die durch das Abtragen der Epitaxieschicht (3) entstanden ist.

## Claims

1. Process for producing microelectromechanical sensors (MEMS), in which sensors (5) and sensor signal-processing electronics (4) are made to be monolithically integrated;
(i) by firmly joining to one another a first silicon wafer (2) containing cavities (2a) and a second wafer (1) supporting an epitaxial layer (3) by high-temperature fusion bonding via the epitaxial layer, so that this epitaxial layer covers at least one of the cavities (2a), and a wafer composite is formed;
(ii) removing the wafer composite from the second wafer (1) as far as the epitaxial layer (3) to a membrane thickness corresponding to the micromechanical part of the sensor (5) or thickness of a further part which is sensitive to mechanical stress and thus finally polishing to form a polished surface;
(iii) wherein after the polishing process, electronic sensor structures (5) positioned to the at least one cavity (2a) are produced jointly with analog and/or digital circuits (4) on the polished surface by means of CMOS technology processes.

2. Process according to claim 1, wherein before the wafer-joining process, structures of electronic circuits (4) are already present in the epitaxial layer (3) on the side which is facing the at least one cavity (2a) after joining.

3. Process according to claim 1, wherein a few electronic sensor structures (5) are provided on the side facing the cavity, and extend to the polished surface at least after wafer joining (1, 2).

4. Process according to claim 3, wherein the few electronic sensor structures form electrically conductive channels (4a).

5. Process according to claim 2, wherein the structures of electronic circuits (4) already present extend to the polished surface at least after wafer joining on the side facing the at least one cavity (2a).

6. Process according to claim 5, wherein the structures of electronic circuits form electrically conductive channels (4a).

7. Process according to claim 1, wherein electronic sensor structures (5) present on the side - facing the cavity (2a) - of the removed epitaxial layer (3a), have such sensors for an analysis of a medium present in the cavity (2a).

8. Process according to claim 1, wherein the removal takes place to a membrane thickness (3a) corresponding to the micromechanical part of the sensor (5) or a thickness of a further part of the second wafer (1) responding to mechanical stress.

9. Process according to claim 3, wherein the electronic structures of the sensor extend to the polished side at least after wafer bonding on the side facing the cavity and have electrically conductive channels (4a).

10. Process according to claim 7, wherein the medium in the cavity (2a) rests on the membrane (3a), which is produced by removal of the epitaxial layer (3).

## Revendications

1. Procédé de fabrication de capteurs micro-électromécaniques (MEMS), dans lesquels des capteurs (5) et une électronique (4) traitant les signaux des capteurs sont ou seront réalisés sous forme monolithique intégrée ;
(i) dans lequel une première plaquette de silicium (2), contenant des cavités (2a), et une deuxième plaquette (1), portant une couche d'épitaxie (3), sont reliées de manière fixe l'une à l'autre via la couche d'épitaxie au moyen d'une liaison par fusion à haute température, de telle sorte que cette couche d'épitaxie couvre au moins une des cavités (2a), et qu'un assemblage de plaquettes se forme ;
(ii) l'assemblage de plaquettes est déblayé à partir de la deuxième plaquette (1) jusque dans la couche d'épitaxie (3) sur une épaisseur de membrane correspondant à la partie micromécanique du capteur (5) ou sur une épaisseur d'une autre partie sensible à une sollicitation mécanique, et pour finir un polissage est effectué pour former une surface polie ;
(iii) après le processus de polissage des structures de capteur (5) électroniques, positionnées par rapport à au moins une cavité (2a), sont générées conjointement avec des circuits (4) analogiques et/ou numériques, sur la surface polie, au moyen d'un procédé de technologie CMOS.

2. Procédé selon la revendication 1, dans lequel, avant le processus de liaison des plaquettes, des structures de circuits (4) électroniques sont déjà présentes dans la couche d'épitaxie (3) sur la face qui, après la liaison, est orientée vers au moins une cavité (2a).

3. Procédé selon la revendication 1, dans lequel quelques structures de capteurs (5) électroniques sont prévues sur la face orientée vers la cavité et, au moins après la liaison des plaquettes (1, 2), passent à travers la surface polie.

4. Procédé selon la revendication 3, dans lequel les quelques structures de capteurs électroniques forment des canaux (4a) électroconducteurs.

5. Procédé selon la revendication 2, dans lequel les structures, déjà existantes de circuits (4) électroniques sur la face orientée vers au moins une cavité (2a), passent, au moins après la liaison des plaquettes, à travers la surface polie.

6. Procédé selon la revendication 5, dans lequel les structures des circuits électroniques forment des canaux (4a) électroconducteurs.

7. Procédé selon la revendication 1, dans lequel des structures de capteurs (5) électroniques, présentes sur la face - orientée vers la cavité (2a) - de la couche d'épitaxie (3a) déblayée, présentent de tels capteurs pour l'analyse d'un milieu contenu dans la cavité (2a).

8. Procédé selon la revendication 1, dans lequel le déblayement sur une épaisseur de membrane (3a) correspondant à la partie micromécanique du capteur (5) ou sur une épaisseur d'une autre partie de la deuxième plaquette (1) sensible à une sollicitation mécanique se produit.

9. Procédé selon la revendication 3, dans lequel les structures électroniques du capteur sur la face orientée vers la cavité traversent vers la face polie au moins après la liaison des plaquettes et présentent des canaux (4a) électroconducteurs.

10. Procédé selon la revendication 7, dans lequel le milieu dans la cavité (2a) est collé contre la membrane (3a) qui est obtenue par le déblayement de matière de la couche d'épitaxie (3).
